# EUROPÄISCHE PATENTSCHRIFT

(11) **EP 3 529 837 B1**
(45) Veröffentlichungstag und Bekanntmachung des Hinweises auf die Patenterteilung: **03.07.2024**
(21) Anmeldenummer: 17787149.8
(22) Anmeldetag: 13.10.2017
(51) Int. Cl.: H01L 31/02, H01L 27/144, H01L 31/024

(54) **LADUNGSLAWINEN-PHOTODETEKTOR-SYSTEM**
AVALANCHE PHOTODETECTOR SYSTEM
SYSTÈME DE PHOTODÉTECTEUR À AVALANCHE

(30) Priorität: 19.10.2016 DE 102016220492
(43) Veröffentlichungstag der Anmeldung: 28.08.2019
(73) Patentinhaber: Fraunhofer-Gesellschaft zur Förderung der angewandten Forschung e.V., 80686 München (DE)
(72) Erfinder: FRESE, Ines, 55120 Mainz (DE)
(74) Vertreter: Pfenning, Meinig & Partner mbB
(86) Internationale Anmeldenummer: PCT/EP2017/076168
(87) Internationale Veröffentlichungsnummer: WO 2018/073112

(56) Entgegenhaltungen:
- EP-A1- 2 293 032
- DE-A1-102014 119 300
- JP-A- 2014 077 658
- BEIJU HUANG ET AL: "A monolithic optical receiver chip for free space visible light communication system", SOLID-STATE AND INTEGRATED CIRCUIT TECHNOLOGY (ICSICT), 2012 IEEE 11TH INTERNATIONAL CONFERENCE ON, IEEE, 29. Oktober 2012 (2012-10-29), Seiten 1-3, XP032334872, DOI: 10.1109/ICSICT.2012.6467906 ISBN: 978-1-4673-2474-8

## Beschreibung

Die vorliegende Erfindung bezieht sich auf ein Ladungslawinen-Photodetektor-System (nachfolgend als LPS abgekürzt) mit einem auf dem Ladungslawinenprinzip beruhenden Ladungslawinen-Photodetektor (bevorzugt einem Halbleiter-Photomultiplier oder einer Avalanche-Photodiode und/oder bevorzugt mit einer intrinsischen Verstärkung) sowie einer dem Ladungslawinen-Photodetektor elektrisch nachgeschalteten Verstärkerelektronik.

Die Erfindung wird dabei nachfolgend vor allen Dingen am Beispiel eines Halbleiter-Photomultipliers als Ladungslawinen-Photodetektor beschrieben. Dies ist aber nicht einschränkend, d.h. anstelle eines solchen Halbleiter-Photomultipliers kann erfindungsgemäß immer auch (sofern nichts Anderes gesagt ist) als Ladungslawinen-Photodetektor eine Avalanche-Photodiode eingesetzt werden.

Die Auswahl eines optischen Detektors hängt von der zu erwartenden Intensität des Lichtsignals im System ab. Bei stärkeren Signalen (beispielsweise beim Einstrahlen einer LED mit optischer Leistung im Milliwatt-Bereich - beispielsweise für Transmissionsmessungen) reicht die Empfindlichkeit einer PIN-Photodiode (Englisch "positive intrinsic negative diode"), bei der ein einziges Photon beim Aufprallen auf die Detektor-Oberfläche nur ein einziges Elektron erzeugt, aus. Bei deutlich schwächeren Signalen, im Bereich von beispielsweise 10 nW bis 50 pW, bedarf es einer zusätzlichen Verstärkung der Signale, entweder durch intrinsische Verstärkung im Detektor oder durch eine Nachverstärkung des Signals nach dem Detektor mittels einer nachgeschalteten Verstärkerelektronik. Dies kann beispielsweise durch Auslösen einer Elektronenlawine in einer Avalanche-Photodiode (nachfolgend abgekürzt: APD) bzw. in einem Photomultiplier (nachfolgend abgekürzt: PMT), mit einem Verstärkungsfaktor von bis zu 10⁵, bzw. mit Hilfe einer nachgeschalteten Elektronik erfolgen.

Eine elektronische Verstärkung bringt allerdings auch einen Nachteil mit sich: Das Dunkelrauschen wird mit verstärkt und die Nachweisgrenze wird beeinträchtigt. Im Messbereich unterhalb von 50 pW kann die Photonendetektion im sog. digitalen Modus (Geiger-Modus) erfolgen und bedarf einer Gesamtverstärkung von > 10⁶, was aber nur mit hochqualitativen PMT bzw. mit Silizium-Photomultipliern (nachfolgend als SiPM abgekürzt) erreicht werden kann und unter Umständen noch einer zusätzlichen Kühlung des Detektors bedarf. In diesen Signalbereich fallen beispielsweise Chemilumineszenz-Signale von einer biofunktionalisierten Oberfläche. Das bedeutet, dass man mehrere Detektoren braucht, um mit einem Gerät starke und schwache Signale zu detektieren, also mehrere Detektoren kombinieren muss.

Für automatisierte Hochdurchsatzgeräte bedeutet dies einen zusätzlichen Aufwand beim Probentransport zwischen mehreren einzelnen Detektoren sowie für Maßnahmen zum Lichtschutz des Photomultipliers.

Zusammenfassend werden somit im Stand der Technik für verschiedene Intensitäten verschiedene Detektoren eingesetzt. Für höhere optische Signalhöhen werden Si- bzw. GaAs-Photodetektoren (PIN-Dioden) und für geringere Signalhöhen werden Silizium-Photomultiplier, basierend auf der Avalanche-Technologie, eingesetzt.

Die DE 10 2014 119300 A1 offenbart ein Verfahren zum Erhöhen des dynamischen Bereichs eines Silizium-Photomultipliers (SiPM), insbesondere in Bezug auf die Detektion großer Strahlungsintensitäten, wobei einzelne Avalanche-Photodioden üblicherweise mit einer Vorspannung über eine Durchbruchspannung hinaus vorgespannt werden, mit der Folge einer Lawinenentladung an Elektronen, die das Ausgangssignal definieren, ist dadurch gekennzeichnet, dass die aus einer einfallenden Strahlungsintensität resultierenden Ausgangssignale durch Veränderung der Vorspannung eingestellt wird, wobei die Ausgangssignale im Integrationsmodus ausgewertet werden.

Die JP 2014077658 A offenbart ein optisches Abstandsmessgerät, bei dem die Lichtempfangselemente Lawinenfotodioden sind und bei dem die Vorspannung der Lawinenfotodiode gesenkt werden kann.

Ausgehend vom Stand der Technik ist es die Aufgabe der vorliegenden Erfindung, ein Ladungslawinen-Photodetektor-System zur Verfügung zu stellen, das die Anwendung mehrerer optischer Messmethoden mit variabler (einfallender) Lichtintensität ermöglicht. Das System soll einen möglichst breiten dynamischen Bereich zur Detektion zur Verfügung stellen. Zudem soll das System nicht zu teuer sein.

Diese Aufgabe wird durch ein Ladungslawinen-Photodetektor-System gemäß Anspruch 1 gelöst. Vorteilhafte Ausführungsvarianten lassen sich den abhängigen Ansprüchen entnehmen.

Die vorliegende Erfindung geht von der Grundidee aus, dass momentan Silizium-Photomultiplier zur Einzelphotonendetektion ausschließlich im Geigerzähler-Modus betrieben werden. Anwendungen sind beispielsweise die Positronen-Emissions-Tomografie sowie die Einzelphotonen-Emissions-Computertomografie oder auch die Detektion schwacher Fluoreszenz-Signale. Die intrinsische Verstärkung von einem SiPM oder einer APD reicht allerdings allein nicht für die Detektion der schwachen Chemilumineszenz-Signale aus. Die vorliegende Erfindung erweitert nun den Einsatzbereich, indem unter anderem der dynamische Bereich eines Ladungslawinen-Photodetektors, LPD, sowohl in die Richtung der schwachen Chemilumineszenz- Signale erweitert, als auch der Einsatz im Ladungsintegrationsmodus (nachfolgend: LI-Modus), der notwendig ist für höhere Photonenströme, ermöglicht wird. Im Rahmen des erfindungsgemäßen Systems wird dabei als Ladungslawinen-Photodetektor insbesondere ein Silizium-Photomultiplier eingesetzt. Silizium-Photomultiplier bestehen in der Regel aus bzw. umfassen in der Regel Arrays von parallel geschalteten Avalanche-Photodioden ("Pixel" oder "Microzellen") mit in der Regel einer effektiven Fläche zwischen 10 und 100 µm², die im Stand der Technik unter einer negativen Vorspannung, oberhalb der Durchbruchvorspannung, im Geigerzähler-Modus (nachfolgend: Geiger-Modus) betrieben werden. Sie bieten neben einer geometrischen Effizienz von 65 bis 70 % den Vorteil einer sehr kleinen Baugröße und einer Verstärkung ("gain") von etwa 10⁷. Der grundsätzliche Aufbau des Ladungslawinenprinzip-Detektors der vorliegenden Erfindung kann diesem Bauprinzip folgen. Das Bauprinzip an sich ist dem Fachmann bekannt, siehe beispielsweise ERAERDS, Patrick, et al. "SiPM for fast photon-counting and multiphoton detection", Optics Express, 2007, 15. Jg., Nr. 22, S. 14539-14549.

Ein wesentliches Merkmal der vorliegenden Erfindung ist nun, dass der Ladungslawinen-Photodetektor nicht nur, wie im Stand der Technik, immer mit einer Vorspannung (intrinsische Verstärkung) betrieben werden kann, sondern dass der Ladungslawinen-Photodetektor erfindungsgemäß wahlweise entweder mit einer solchen Vorspannung oder ohne eine solche Vorspannung (mit anderen Worten: ganz ohne Vorspannung) betrieben werden kann. Hierunter wird erfindungsgemäß verstanden, dass der Ladungslawinen-Photodetektor dazu geeignet ist bzw. dazu konfiguriert ist, entweder mit einer solchen Vorspannung oder ohne Vorspannung betrieben zu werden.

Unter Merkmalen, die den Betrieb des Ladungslawinen-Photodetektor-Systems und/oder den Betrieb seiner Bestandteile beschreiben (Verfahrensmerkmale), werden Merkmale verstanden, für deren Ausführung das Ladungslawinen-Photodetektor-System und/oder seine Bestandteile geeignet bzw. konfiguriert ist/sind.

Beispielsweise kann der Ladungslawinen-Photodetektor erfindungsgemäß ohne negative Vorspannung arbeiten, so dass der Detektor als gewöhnliches PIN-Diodenarray mit einem der Pixelgröße entsprechenden, niedrigen Dunkelrauschen und einer Sensitivität, die der einer Si-PIN-Diode entsprechen kann, funktionieren kann. Wird die dem Ladungslawinen-Photodetektor elektrisch nachgeschaltete Verstärkerelektronik (also die elektrisch mit dem Ladungslawinen-Photodetektor verbundene Verstärkerelektronik) angeschaltet (bzw. verstärkt diese), so kann der Empfindlichkeitsbereich zwischen dem Modus einer PIN-Photodiode und dem Geigerzähler-Modus abgedeckt werden. Zusätzlich kann auch im Geigerzähler-Modus mit einer Vorspannung gearbeitet werden: Es ist damit erfindungsgemäß möglich, basierend auf einem Ladungslawinen-Photodetektor (insbesondere: Silizium-Photomultiplier), einen universellen Detektor mit einem dynamischen Bereich von bis zu 10 Dekaden zu realisieren.

Nachfolgend werden für die Beschreibung der Erfindung folgende Abkürzungen verwendet:
- Ladungslawinen-Photodetektor-System = LPS bzw. LP-System
- Ladungslawinen-Photodetektor = LPD (bevorzugte Variante: Silizium-Photomultiplier = SiPM)
- Verstärkerelektronik = VE
- Vorspannung bzw. Betriebs-Vorspannung bzw. Bias-Spannung = V_{bias}

Ein erfindungsgemäßes LPS ist im Anspruch 1 beschrieben.

Das erfindungsgemäße LPS kann in Avalanche-Technologie realisiert sein bzw. auf Basis des Avalanche-Prinzips aufgebaut sein. Die (Betriebs-)Vorspannung V_{bias} wird alternativ auch als Bias-Spannung bezeichnet. Bei dieser Vorspannung handelt es sich in der Regel um eine negative Vorspannung, mit der der LPD bzw. die einzelnen Avalanche-Photodioden des Arrays aus parallel geschalteten Avalanche-Photodioden des LPD betrieben wird/werden. Aufbau und Funktionsweise eines solchen LPD ist dem Fachmann grundsätzlich bekannt, vgl. z. B. Kapitel "1.2 Photodetektoren mit Lawineneffekt-Siliziumphotomultiplier" in der Diplomarbeit "KLAuS und STiC - Zwei ASICs zur präzisen Energie- und Zeitmessung" von Konrad Briggl, Ruprecht-Karls-Universität Heidelberg, Oktober 2012.

Im Betrieb mit einer Vorspannung V_{bias} ist diese betragsmäßig erfindungsgemäß in der Regel auf einen Wert größer als die Durchbruchspannung V_{durch} ("breakdown voltage") eingestellt. Mit anderen Worten, wenn V_{bias} ≠ 0 gegeben ist (also das LPS momentan mit einer Vorspannung betrieben wird), wird das LPS in der Regel ähnlich wie eine verstärkte PIN-Diode eingesetzt. Wenn V_{bias} → V_{bias}, ₘₐₓ. geht das LPS in den Geiger-Modus (zur Einzelphotonendetektion bzw. im Ladungszählmodus) über, es gilt also V_{bias} > V_{durch}.

Vorteilhafterweise realisierbare Merkmale lassen sich Anspruch 2 entnehmen.

Das LP-System bzw. dessen VE kann also über ein Mittel verfügen, mittels dessen die am LPD bzw. an den einzelnen Avalanche-Photodioden des Arrays des HPLM anliegende Bias-Spannung V_{bias} zwischen unterschiedlichen (negativen) Spannungswerten sowie dem Wert V_{durch} (V_{bias} ≤ V_{durch} gleich gesetzt dem Wert 0: die Vorspannung, die keine intrinsische Verstärkung auslöst) veränderbar ist.

Dieses Mittel kann beispielsweise eine Software-basierte Schaltung sein. Beispielsweise kann eine Benutzeroberfläche generiert bzw. angewendet werden, bei der beispielsweise Maus-basiert entsprechende Schaltfelder (engl. "buttons") angeklickt werden können. Durch dieses Anklicken kann die am LPD bzw. an den einzelnen Avalanche-Photodioden des Arrays des HPLM anliegende V_{bias} zwischen den unterschiedlichen Spannungswerten bzw. dem Wert 0 verändert werden.

Ebenso ist als Mittel eine Event-basierte Schaltung denkbar: Es kann eine Messung beispielsweise von der niedrigsten in Richtung zur höchsten Empfindlichkeit durchgeführt werden und beim ersten Auftreten von Messsignalen (als auslösendes Event) kann der passende Bereich ausgewählt werden.

Erfindungsgemäß kann also die Schaltung zur Veränderung der V_{bias} in die VE integriert sein. Ein entsprechendes Steuerungsprogramm kann auf LabView basieren (es sind aber auch andersartige Steuerprogramme denkbar). Die Schaltung zur Veränderung bzw. das Steuerprogramm kann alle Messabläufe inkl. des Umschaltens steuern. Die Schaltung zur Veränderung bzw. das Steuerprogramm kann durch Anklicken bestimmter Auswahlkästchen (die beispielsweise mit "Chemilumineszenz" oder "Absorbanz"/"Absorption" gekennzeichnet sind) ermöglichen, das dem jeweiligen Auswahlkästchen entsprechende Programm mit einprogrammierten Einstellungen für "mit/ohne Vorspannung" und/oder "mit/ohne elektrische Verstärkung" auszuwählen und zu aktivieren (also beispielsweise ein Programm auszuwählen, bei dem der LPD mit V_{bias} betrieben wird und bei dem die VE angeschaltet ist, also ihrerseits ebenfalls verstärkt).

Alternativ dazu ist es erfindungsgemäß aber auch möglich, eine separate, also eine nicht der VE angehörige bzw. eine nicht in die VE integrierte, Schaltung zu verwenden, die ausgebildet ist zum Umschalten vom Betrieb mit einer V_{bias} zum Betrieb ohne eine solche V_{bias} oder umgekehrt.

Weitere vorteilhafterweise realisierbare Merkmale lassen sich dem Anspruch 3 entnehmen.

Im Rahmen der Anspruchsstruktur lassen sich sämtliche Einzelmerkmale der vorliegenden Erfindung auch auf andere Art und Weise als nachfolgend beschrieben realisieren. So können beispielsweise einzelne Merkmale aus dem nachfolgenden Ausführungsbeispiel hinzugefügt oder weggelassen werden.

Jeder der beiden Moden (Betrieb des LPD mit Vorspannung bzw. ohne Vorspannung) kann also mit der Verstärkungselektronik kombiniert werden (entsprechender Modus mit angeschalteter VE) oder auch nicht (entsprechender Modus mit abgeschalteter VE). Ein Anschalten der VE bedeutet, dass diese mit einem Verstärkungsfaktor (nachfolgend auch als "VF" abgekürzt), arbeitet, dass also VF > 1 gilt, dass die VE also eine (echte) Signalverstärkung vornimmt. Ein Abschalten der VE bedeutet, dass diese das ihr vom LPD zugeführte Signal (also das vom LPD detektierte Signal) nicht verstärkt, also dessen Signalstärke unverändert belässt. Die VE kann dabei über mehrere unterschiedliche Verstärkerstufen verfügen, die beispielsweise Verstärkungsfaktoren wie folgt ermöglichen: 1 < VF < 7,5 * 10⁷ (Gesamtverstärkung der VE).

Erfindungsgemäß kann in der VE (oder in einer/der separaten, also nicht der VE angehörigen Schaltung) eine Auswahl von Verstärkungsfaktoren bzw. von Verstärkerstufen hinterlegt werden. Es können beispielsweise im Rahmen von Vortests Verstärkungsfaktoren ermittelt werden. Software-basiert (beispielsweise über ein/das z. B. auf LabView basierende(s) Steuerungsprogramm) können definierten Kombinationen (jeweils aus einem VF und einer Vorspannung) definierten Messmethoden (beispielsweise "Chemilumineszenz" oder "Absorbanz") zugeordnet werden. Durch die Auswahl einer solchen Messmethode ist eine konkrete Kombination aus VF und V_{bias} einstellbar bzw. wird eingestellt.

Erfindungsgemäß ist aber auch ein anderes Szenario möglich, in dem im Rahmen eines Vortests Software-basiert ein Programm eine Kombination entsprechend einer zu messenden Signalhöhe automatisch auswählt (beispielsweise basierend auf dem niedrigsten Signal-zu-Rausch-Verhältnis). Diese Kombination kann daraufhin als eine neue (beispielsweise kundenspezifische) Messmethode abgespeichert, also im LPS hinterlegt werden.

Dazu bzw. ganz allgemein kann das erfindungsgemäße LPS computergestützt realisiert sein bzw. arbeiten, also ein geeignetes Rechnersystem (beispielsweise einen Personal Computer PC oder einen Server) samt Mikroprozessor und Programm-Speicher zum Ablegen bzw. Speichern eines Steuerprogramms (oder mehrerer Steuerprogramme) und/oder einer oder mehrerer Messmethode(n) umfassen.

Weitere vorteilhafterweise realisierbare Merkmale sind Anspruch 4 zu entnehmen.

Die genannten Moden als solche sind dem Fachmann grundsätzlich bekannt, vgl. beispielsweise "Kapitel 1. Einführung" in der bereits erwähnten Diplomarbeit "KLAuS und STiC - Zwei ASICs zur präzisen Energie- und Zeitmessung".

Bei geringen Signalintensitäten des einfallenden Lichts bzw. bei geringer Anzahl der pro Flächen- und Zeiteinheit auftreffenden Photonen (beispielsweise Chemi- oder Biolumineszenz) kann der LPD somit im Geiger-Modus betrieben werden. Bei höheren und hohen Signalintensitäten des einfallenden Lichts bzw. bei höherer oder hoher Anzahl der pro Flächen- und Zeiteinheit auftreffenden Photonen (beispielsweise Fluoreszenz- und/oder Absorbanz-Messungen an niedrig- bzw. hochkonzentrierten Analyten) kann der LPD somit im Ladungsintegrationsmodus betrieben werden.

Erfindungsgemäß kann beispielsweise zwischen dem Geiger-Modus und dem Ladungsintegrationsmodus (LI-Modus) gewechselt werden, indem für die Ladungsintegration betragsmäßig V_{bias} > V_{durch} eingestellt wird bzw. für den Geiger-Modus betragsmäßig V_{bias} → V_{bias}, ₘₐₓ. eingestellt wird. Erfindungsgemäß kann der auf einer intrinsischen Verstärkung basierende Geiger-Modus durch eine Kombination mit einer/der elektronischen Verstärkung mit einem niedrigen Hintergrundrauschen in die Richtung von noch schwächeren Signalen erweitert werden.

Bei der erfindungsgemäßen elektronischen Verstärkung VE kann es sich um eine mehrstufige Verstärkung mit einem Nullabgleich vor der letzten Verstärkungsstufe handeln. Einzelne Verstärkungen ("gains") können methodenspezifisch festgelegt werden. Damit ist erfinderungsgemäß eine universelle Plattform für die Realisierung eines Messsystems geschaffen. Das Messsystem kann für alle erdenklichen Kombinationen optischer Messmethoden mit kundenspezifischen Anforderungen realisiert werden.

Erfindungsgemäß kann beispielsweise einfach manuell in den Geiger-Modus umgeschaltet werden, wenn nach Beobachten von am Bildschirm des LPS angezeigter Messwerte festgestellt wird, dass die Zahl bzw. die Intensität für den Ladungsintegrationsmodus zu gering ist.

Welche Messmethode bzw. welcher Modus gerade angewendet wird, kann der zu vermessende chemische Analytik-Kit bestimmen. Die Chemie für die Probenpräparation wird üblicherweise für die Messung mit einer bestimmten Methode (Absorption, Fluoreszenz oder Chemilumineszenz) ausgelegt. Das LPS kann also für ein bestimmtes Spektrum von chemischen Analytik-Kits ausgelegt werden; die anzuwendenden Messmethoden sind dadurch vordefiniert. (Im Stand der Technik existieren verschiedene Geräte in verschiedenen Preisklassen abhängig von der Anzahl der Messmethoden und der Breite der zugelassenen Analytik-Kits. Besonders bei den universellen Stand der Technik-Geräten für mehrere Messmethoden führt die Notwendigkeit des Einbaus von mehreren Detektoren zu einer deutlichen Preiserhöhung. Der hier beschriebene Detektor bzw. das hier beschriebene LPS löst diese Problematik.)

Die für konkrete Kombinationen der Messmethoden festzulegenden Verstärkungen ("gains") einzelner Verstärkungsstufen können erfindungsgemäß im Rahmen von Vortests (z.B. feststellen des Minimums und/oder des Maximums der zu erwartenden bzw. der gemessenen Intensitäten) bestimmt werden (bei jeder Messmethode unterschiedlich), können also anhand zu erwartender Signalintensitäten bestimmt werden. Während der Tests können festgelegte, der konkreten Messmethode entsprechende Verstärkungen Software-basiert manuell eingestellt werden.

Es ist aber erfindungsgemäß auch denkbar, die Software durch eine Modusauswahl-Subroutine zu erweitern, die in einem automatisierten Vortest anhand der bei einer konkreten Messmethode maximal und minimal messbaren Signalstärke die optimale Verstärkung (gain) für die einzelnen Verstärkungsstufen ermittelt. Im Betrieb des LP-Systems kann dabei (beispielsweise durch das Einlesen eines Strichcodes) dem Analytik-Kit eine entsprechende Messmethode mit dem dazu gehörenden gain automatisch zugeordnet werden (bzw. im Gerät aktiviert werden).

Weitere vorteilhafterweise realisierbare Merkmale lassen sich Anspruch 5 entnehmen.

Im Rahmen der Erfindung wird alternativ zum Begriff des Gesamtverstärkungsmodus bzw. Messmodus auch der Begriff des Gain-Modus verwendet.

Der Gesamtverstärkungsmodus 0 ist vergleichbar mit einer PIN-Photodiode. Der Gesamtverstärkungsmodus 1 ist vergleichbar mit einer verstärkten PIN-Photodiode. Der Gesamtverstärkungsmodus 2 ist vergleichbar mit einem LPD mit Vorspannung bzw. einem handelsüblichen PMT (Photomultiplier Tube). Wobei sich die Gesamtverstärkungsmodi 1 und 2 überlappen können. Der Gesamtverstärkungsmodus 3 ist vergleichbar mit einem gekühlten Photomultiplier mit Vorspannung.

Welcher der besagten vier Gesamtverstärkungsmoden gerade verwendet wird, kann festgelegt werden, indem manuell umgeschaltet wird, wenn beispielsweise nach Beobachten der am Bildschirm angezeigten Messwerte festgestellt wird, dass die auftreffende Photonenzahl bzw. -intensität für den gerade gewählten Modus unpassend ist. Im erfindungsgemäßen LPS kann das Messsignal nach jeder Verstärkungsstufe ausgelesen werden und beispielsweise mit LabView auf dem Bildschirm angezeigt werden. Zum Vermessen der Analytik-Kits kann man dadurch den passenden Modus aus den vorhandenen Moden auswählen, einer Messmethode zuweisen und im LPS abspeichern.

Ist ein Messsignal zum Beispiel auf dem Anschlag oben oder unten, so weiß der Benutzer, dass der gerade eingestellte Messmodus nicht passt. Der notwendige dynamische Messbereich wird üblicherweise für einen konkreten Analytik-Kit in einem Test (Vortest) ausgelotet. Fehlsignale deuten dabei auf fehlgelaufene chemische Reaktionen hin und somit auf die Notwendigkeit einer Testwiederholung.

Wie beschrieben ist es aber auch (beispielsweise Software-basiert) möglich, automatisch umzuschalten.

Das Ausgestalten mit diesen vier möglichen Gesamtverstärkungsmoden bietet insbesondere den Vorteil, dass das erfindungsgemäße LPS (also: dass genau ein einziges Detektorsystem) universell für die Messung sowohl optischer Chemilumineszenz-Signale (bevorzugt: im Gesamtverstärkungsmodus 3, insbesondere mit dem LPD im Geiger-Modus sowie mit maximaler intrinsischer und elektronischer Verstärkung der angeschalteten VE), als auch optischer Fluoreszenz-Signale (bevorzugt: im Gesamtverstärkungsmodus 1 oder im Gesamtverstärkungsmodus 2, ggf. auch im Gesamtverstärkungsmodus 3 bei in der Regel geringer Verstärkung der angeschalteten VE), als auch optischer Absorptions-Signale (bevorzugt: im Gesamtverstärkungsmodus 0 oder im Gesamtverstärkungsmodus 1) geeignet ist.

Damit sind Messungen mit nahezu beliebiger optischer Signalintensität möglich. Die Erfindung ermöglicht somit, dass man nicht mehr mehrere unterschiedliche optische Detektoren bzw. Photodetektoren im System benötigt, um sowohl schwache, als auch starke optische Signale zu erfassen.

Mit dem LPS kann erfindungsgemäß nicht nur der sichtbare Spektralbereich zwischen etwa 380 nm und 750 nm erfasst bzw. abgetastet werden, sondern es können beispielsweise auch die folgenden Wellenlängenbereiche erfasst bzw. vermessen werden:
- SiPM ohne eine Schutzschicht: Ab 200 nm aufwärts.
- SiPM mit einer Polymerschutzschicht: ca. 350 nm bis 900 nm.
- InGaAs-Avalanche-Photodiode: ca. 0,9 µm bis 1,7 µm.

Weitere vorteilhafterweise realisierbare Merkmale lassen sich Anspruch 6 entnehmen.

Grundsätzlich ist im Rahmen der Erfindung als LPD aber auch eine Ge-Avalanche-Photodiode (Ge-APD) oder eine InGaAs-APD einsetzbar.

Weitere erfindungsgemäße Merkmale, die realisiert werden können, lassen sich Anspruch 7 entnehmen.

Siehe hierzu auch nachfolgendes Ausführungsbeispiel.

Die maximale Verstärkung eines solchen, dreistufigen Transimpedanz-Verstärkers kann z. B. 3,75 * 10⁷ (also 10⁶ * 7,5 * 5 pro Stufe) bzw. 7,5 * 10⁷ (also 10⁶ * 7,5 * 10 pro Stufe) betragen. Eine solche Verstärkung wird beispielsweise zum Erfassen schwacher Chemilumineszenz-Signale verwendet.

Erfindungsgemäß kann ein Drei-Stufen-Transimpedanz-Verstärker verwendet werden, es können also drei übliche bzw. dem Fachmann hinsichtlich ihres Aufbaus grundsätzlich bekannte (siehe z.B. Göbel, Holger "Einführung in die Halbleiter-Schaltungstechnik", Springer-Verlag, 2014), nacheinandergeschaltete Transimpedanz-Verstärker mit einem Nullabgleich sowie mit einem Filter dazwischen (beispielsweise: Fast-Fourier-Transformations-Filter, FFT-Filter) verwendet werden.

Weitere vorteilhafterweise realisierbare Merkmale lassen sich den Ansprüchen 8 und 9 entnehmen.

Siehe dazu auch das nachfolgende Ausführungsbeispiel.

Erfindungsgemäß können die zu messenden Lichtsignale von funktionalisierten Böden von Töpfchen eines Teststreifens in Mikrotiterformat kommen. Der Abstand (von beispielsweise 10 mm) zwischen den Töpfchen und einem erfindungsgemäßen LPD bzw. SiPM kann durch einen hohlen, metallischen Wellenleiter überbrückt werden. Ein solcher hohler Wellenleiter kann eingesetzt werden, um einem abstandsabhängigen Signalabfall auf besagter Distanz von beispielsweise 10 mm entgegenzuwirken.

Die vorliegende Erfindung ermöglicht somit, einen LPD, insbesondere einen SiPN, mit einer VE elektrisch bzw. elektronisch zu verbinden sowie den LPD bei höheren Signalen in einem Ladungsintegrationsmodus und bei sehr geringen Signalen im Geigerzähler-Modus zu betreiben. Damit stellt die Erfindung ein kostengünstiges, universelles Detektionsmodul zur Verfügung, das Messungen mit nahezu beliebiger optischer Signalintensität ermöglicht (zwischen Einzelphotonennachweisen < 10 Photonen pro Sekunde bis hin zu 4 * 10⁷ Photonen pro Sekunde bzw. bis hin zur Multiphotonendetektion im Bereich von mehreren mW/cm²). Die Gesamtverstärkung des LPS bzw. des Moduls kann schrittweise, insbesondere Software-basiert zwischen Geigerzähler- und Ladungsintegrationsmodus geändert werden. Damit ist es möglich, sowohl Absorbanz-Messungen, als auch Chemilumineszenz-Messungen am Boden eines Wells einer Mikrotiterplatte durchzuführen. Zwischen den beiden genannten Messarten muss nur die Mikrotiterplatte ausgewechselt werden, die Vorspannung ausgeschaltet werden und z. B. ein Verstärkerkanal Software-basiert gewechselt werden.

Mit dem erfindungsgemäßen Detektionsmodul ist die Anwendung vieler optischer Messmethoden mit variabler Intensität (dynamischer Bereich bis zu 10 Dekaden) vom Einzelphotonennachweis bis in den Milliwattbereich möglich. Dies zudem auf vergleichsweise günstige Art und Weise.

Ein wesentlicher Punkt der Erfindung ist somit, dass bereits alleine durch den Betrieb mit oder ohne Vorspannung ein deutlich größerer Bereich detektiert werden kann. Die Messung von Chemilumineszenz, Absorption und Fluoreszenz ist erfindungsgemäß mit einem einzigen Detektor möglich. Die zu messenden Lichtsignale können von funktionalisierten Böden zweier oder dreier (oder auch von mehr als drei) der Töpfchen z. B. eines 1x8-Teststreifens in Mikrotiterformat kommen. Beispiel: Absorptionsmessung in einem Flüssigkeitsvolumen von 100 µl bei Anregung und Messung bei einer Wellenlänge von λ = 650 nm. Weiteres Beispiel: Chemilumineszenz-Messung auf der mit Flüssigkeit (100 µl) bedeckten Oberfläche bei einer Wellenlänge von λ = 460 nm ohne Anregung. Es ist somit mit einem einzigen Detektor integrativ eine Absorptions- und eine Chemilumineszenz-Messung möglich.

Es wird ferner die Verwendung des erfindungsgemäßen Ladungslawinen-Photodetektor-Systems zur Photodetektion vorgeschlagen, wobei der Halbleiter-Photomultiplier wahlweise (entweder) mit einer Vorspannung V_{bias} oder ohne Vorspannung V_{bias} betrieben wird. Die oben im Zusammenhang mit dem Ladungslawinen-Photodetektor-System beschriebenen Merkmale können auch Merkmale der erfindungsgemäßen Verwendung sein.

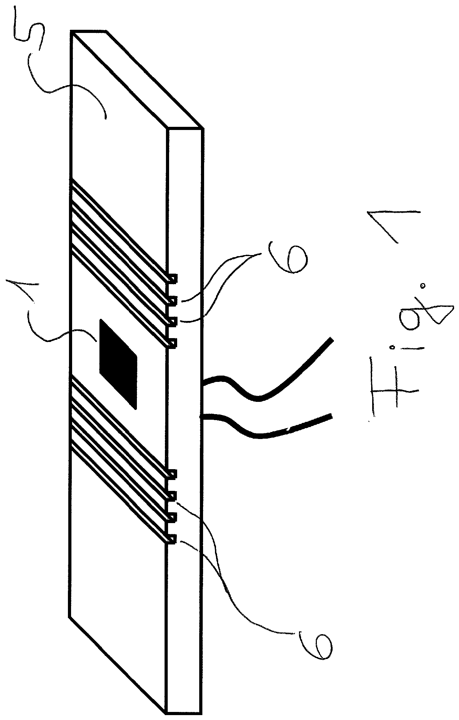

Nachfolgend werden anhand eines konkreten Aufbaus Messergebnisse beispielhaft in Form eines Ausführungsbeispiels dargestellt. Dabei zeigt
Figur 1
   ein erfindungsgemäßes SiPM-Modul für Messungen von Chemilumineszenz und Absorption.
Figur 2
   die dem Modul aus Fig. 1 nachgeschaltete VE.
Figur 3
   den Aufbau aus SiPM und aus der nachgeschalteten VE.
Figur 4
   ein Beispiel einer Chemilumineszenz-Messung.
Figur 5
   ein Beispiel einer Absorptionsmessung.

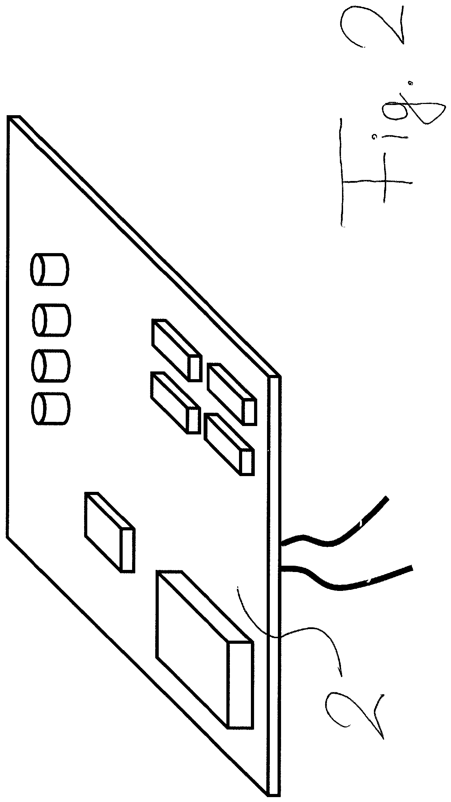

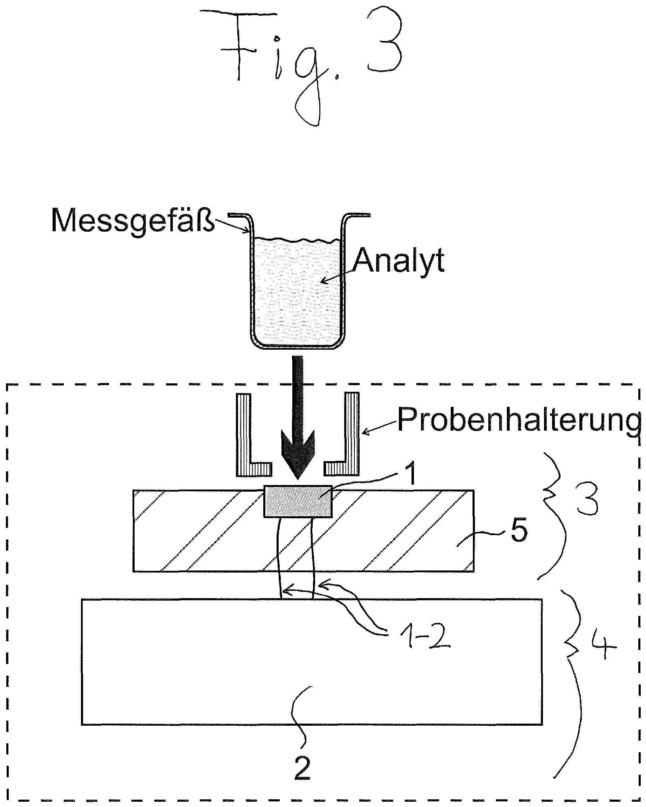

Figur 1 zeigt das erfindungsgemäße Beispielmodul (SiPM-Modul) 3, vgl. Figur 3, mit dem SiPM 1, der mittig in einen Kühlkörper 5 eingebettet ist. Das Bezugszeichen 6 bezeichnet Kühlrippen, die beidseits unmittelbar benachbart zum SiPM 1 in den Kühlkörper 5 eingelassen sind. Figur 2 zeigt die Verstärkerelektronik VE 2, die dem in Figur 1 gezeigten SiPM 1 bzw. dem entsprechenden SiPM-Modul 3 (vgl. Figur 3) nachgeschaltet 1-2 ist. Figur 3 zeigt den gesamten Aufbau aus dem SiPM-Modul 3 mit dem SiPM 1, dem das VE-Modul 4 mit der VE 2 elektrisch bzw. elektronisch (über geeignete Kabelverbindungen) nachgeschaltet ist. Die beiden Module 3 und 4 sind dabei räumlich voneinander beabstandet bzw. getrennt, damit die von der VE 2 bzw. dem Modul 4 produzierte Wärme vom Modul 3 bzw. SiPM 1 ferngehalten wird. In Figur 3 ist neben der VE (bzw. der SiPM-Ansteuerelektronik) auch der Drei-Stufen-Transimpedanzverstärker der VE erkennbar.

Der SiPM arbeitet im Avalanche-Modus mit einer Vorverstärkung von etwa Minus 28 Volt. Der Drei-Stufen-Transimpedanzverstärker der VE weist einen Gesamt-Gain von etwa 3,75 * 10⁷ (also 10⁶ * 7,5 * 5 pro Stufe), notwendig für Messungen der Chemilumineszenz, auf. Eine entsprechende Messmoduswahl bzw. Schaltung ermöglicht eine Messung der Absorption mit der ersten Gain-Stufe von 10⁶ (ohne Bias-Spannung). Da eine Chemilumineszenzmessung eine deutlich höhere Sensitivität erfordert, wurde die VE an die Chemilumineszenzmessung angepasst, mit der Option für eine Absorptionsmessung oder für eine Fluoreszenzmessung (unter Software-basiertem Wechsel der Verstärkung bzw. des Gains).

Der Abstand zwischen dem Töpfchen und dem SiPM beträgt 10 mm und wird durch einen hohlen, metallischen Wellenleiter (z. B. eine Bohrung im Aluminium-Drehteller) überbrückt.

Eine typische Schrittfolge für die Durchführung und Auswertung einer Chemilumineszenzmessung ist wie folgt:
1. Platzieren der Referenzprobe.
2. Setzen von V_{bias} (typischerweise betragsmäßig 28 - 30 V).
3. Setzen des Hintergrund-Signalpegels (nachfolgend: CL-Signal auf -1,5 V).
4. Abtasten des CL-Signals, um die Ausgangsspannung zu überprüfen.
5. Setzen von V_{bias} auf 0.
6. Platzieren der Probe.
7. Setzen von V_{bias} auf den vorherigen Wert.
8. Abtasten des CL-Signals (Abtastrate 2 Hertz: 10 Werte innerhalb von etwa 5 Sekunden).
9. Setzen von V_{bias} auf 0 V (Volt).
10. Optional kann noch einmal eine Referenzmessung durchgeführt werden.

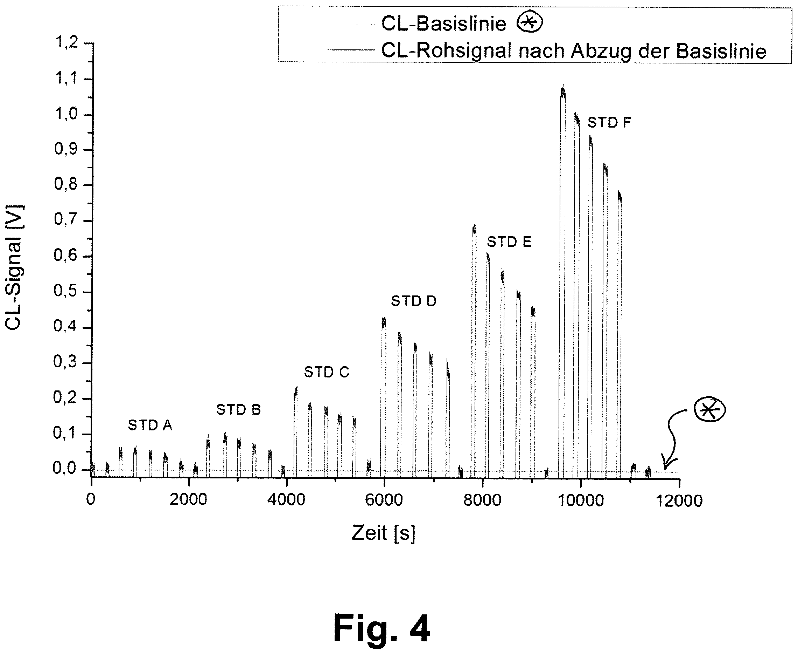

Ein Ergebnis für eine solche Chemilumineszenzmessung zeigt das Beispiel von Figur 4. Merkmale sind wie folgt:
- Signalhub zwischen Standard B und Standard E von bis zu 2 Volt bei einer Elektronik-spezifischen Auflösung von 0,01 Volt.
- Dynamischer Bereich des SiPM kann durch Nullabgleich auf -2 Volt den Wert von 4,5 Volt erreichen.
- Die Basislinie wurde aufgenommen an Töpfchen gefüllt mit Luminol, aber ohne Inkubation von Standard und Konjugat.
- Die Luminol-Lösung war bei dieser Messung etwas abgeschwächt.

Eine typische Schrittfolge für die Durchführung und Auswertung einer Absorptionsmessung ist wie folgt:
1. Setzen von V_{bias} auf 0 Volt.
2. Setzen des Offset auf 0 Volt.
3. Platzieren der Referenzprobe.
4. Abtasten des Absorptionssignals.
5. Platzieren der eigentlichen Probe.
6. Abtasten des Absorptionssignals (Abtastrate von 2 Hertz: 10 Werte innerhalb von etwa 5 Sekunden).
7. Bestimmung der Absorption aus der Referenzmessung einerseits und der Probenmessung andererseits: A = -LOG ( (Signal_{Probe}) / (zu Beginn der Messung bestimmtes Referenzsignal)).

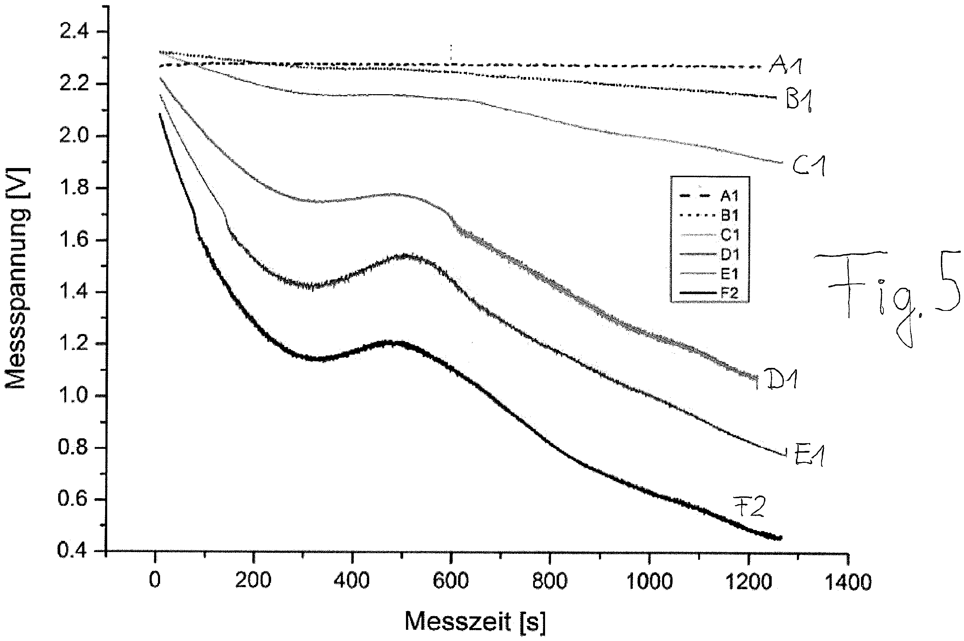

Figur 5 zeigt das Ergebnis einer beispielhaften Absorptionsmessung (Rohdaten). Dabei gilt Folgendes:
- Anregung mit einer RGB-LED (λ = 565 nm).
- Die Beispielmessungen wurden mit 80 % der maximalen LED-Leistung (35 mA) aufgenommen.
- Signalhub innerhalb von 20 Minuten bis 2 Volt.
- Messung während einer Farbwechselreaktion.
- Der dynamische Bereich beträgt maximal 4,5 Volt.
- Die Signalspitze bei einer Messzeit von etwa 500 sec wird durch eine diffusionsgesteuerte Farbwechselreaktion verursacht.

## Patentansprüche

1. Ladungslawinen-Photodetektor-System (LP-System) mit einem auf dem Ladungslawinenprinzip beruhenden Ladungslawinen-Photodetektor (1), bevorzugt einem Halbleiter-Photomultiplier oder einer Avalanche-Photodiode,
wobei das LP-System eine dem Ladungslawinen-Photodetektor (1) elektrisch nachgeschalteten (1-2) Verstärkerelektronik (2) hat,
wobei der Ladungslawinen-Photodetektor (1) wahlweise entweder mit einer Vorspannung V_{bias} oder ohne eine solche Vorspannung V_{bias} betreibbar ist,
**dadurch gekennzeichnet, dass** das LP-System, sowohl im Betrieb des Ladungslawinen-Photodetektors (1) mit einer Vorspannung V_{bias} als auch im Betrieb des Ladungslawinen-Photodetektors (1) ohne eine solche Vorspannung V_{bias}, wahlweise entweder mit angeschalteter Verstärkerelektronik (2) oder mit abgeschalteten Verstärkerelektronik (2) betreibbar ist,
wobei die Verstärkerelektronik (2) einen mehrstufigen Transimpedanzverstärker umfasst.

2. LP-System nach dem vorhergehenden Anspruch,
***dadurch gekennzeichnet, dass***
ein Umschalten vom Betrieb mit einer Vorspannung V_{bias} zum Betrieb ohne eine solche Vorspannung V_{bias} oder umgekehrt mittels der Verstärkerelektronik (2), bevorzugt mittels einer in die Verstärkerelektronik (2) integrierten Ansteuerungselektronik, erfolgt.

3. LP-System nach einem der vorhergehenden Ansprüche,
***dadurch gekennzeichnet, dass***
der Ladungslawinen-Photodetektor (1) zwischen dem Geiger-Modus, einem Ladungsintegrationsmodus und/oder einem Modus einer PIN-Photodiode umschaltbar ist.

4. LP-System nach einem der vorhergehenden Ansprüche,
***dadurch gekennzeichnet, dass***
das LP-System in den folgenden Messmoden betreibbar ist, also von einem beliebigen zu einem anderen beliebigen der nachfolgend aufgeführten Messmoden umschaltbar ist oder zumindest jeweils zwischen unmittelbar benachbarten Messmoden gemäß der nachfolgenden Reihenfolge umschaltbar ist:
• Gesamtverstärkungsmodus 0: Betrieb des Ladungslawinen-Photodetektors (1) ohne eine Vorspannung V_{bias} sowie Verstärkerelektronik (2) abgeschaltet.
• Gesamtverstärkungsmodus 1: Betrieb des Ladungslawinen-Photodetektors (1) ohne eine Vorspannung V_{bias} sowie Verstärkerelektronik (2) angeschaltet.
• Gesamtverstärkungsmodus 2: Betrieb des Ladungslawinen-Photodetektors (1) mit Vorspannung V_{bias} sowie Verstärkerelektronik (2) abgeschaltet.
• Gesamtverstärkungsmodus 3: Betrieb des Ladungslawinen-Photodetektors (1) mit Vorspannung V_{bias} sowie Verstärkerelektronik (2) angeschaltet.

5. LP-System nach einem der vorhergehenden Ansprüche,
***dadurch gekennzeichnet, dass***
der Ladungslawinen-Photodetektor (1) ein(en) Silizium-Photomultiplier, SiPM, ist oder umfasst.

6. LP-System nach einem der vorhergehenden Ansprüche,
***dadurch gekennzeichnet, dass***
der mehrstufige Transimpedanzverstärker ein dreistufiger Transimpedanzverstärker ist.

7. LP-System nach einem der vorhergehenden Ansprüche,
***dadurch gekennzeichnet, dass***
der Ladungslawinen-Photodetektor (1) in/als ein(em) ersten/s Modul (3) ausgebildet ist und dass die Verstärkerelektronik (2) in/als ein(em) zweiten/s Modul (4) ausgebildet ist,
wobei bevorzugt das erste Modul (3) und das zweite Modul (4) räumlich beabstandet voneinander angeordnet sind.

8. LP-System nach einem der vorhergehenden Ansprüche,
***dadurch gekennzeichnet, dass***
der Ladungslawinen-Photodetektor (1) eingebettet ist oder angeordnet ist in/an ein(em) Kühlelement (5), insbesondere in/an einen/m Kühlkörper.

9. Verwendung eines LP-Systems gemäß einem der Ansprüche 1 bis 8 zur Photodetektion, wobei der Halbleiter-Photomultiplier (1) wahlweise entweder mit einer Vorspannung V_{bias} oder ohne Vorspannung V_{bias} betrieben wird.

## Claims

1. A charge avalanche photodetector system (CAPD system) with a charge avalanche photodetector (1) based on the charge avalanche principle, preferably with a semiconductor photomultiplier or an avalanche photodiode,
wherein the CAPD system has amplifier electronics (2) electrically connected downstream (1-2) of the charge avalanche photodetector (1),
wherein the charge avalanche photodetector (1) is selectively operable either with a bias voltage V_{bias} or without such a bias voltage V_{bias},
**characterized in that** the CAPD system, both in operation of the charge avalanche photodetector (1) with a bias voltage V_{bias} and in operation of the charge avalanche photodetector (1) without such a bias voltage V_{bias}, is operable selectively either with the amplifier electronics (2) switched on or with the amplifier electronics (2) switched off,
wherein the amplifier electronics (2) comprises a multi-stage transimpedance amplifier.

2. CAPD system in accordance with the preceding claim, **characterized in that** a switchover from operation with a bias voltage V_{bias} to operation without such a bias voltage V_{bias}, or vice versa, takes place by means of the amplifier electronics (2), preferably by means of control electronics integrated in the amplifier electronics (2).

3. CAPD system in accordance with one of the preceding claims, **characterized in that** the charge avalanche photodetector (1) is switchable between the Geiger mode, a charge integration mode and/or a mode of a PIN photodiode.

4. CAPD system in accordance with one of the preceding claims,
**characterized in that** the CAPD system is operable in the following measurement modes, that is can be switched over from any one measurement mode to any other one of the measurement modes listed below, or can at least be switched over between respective directly adjacent measurement modes in accordance with the following order:
• Total gain mode 0: Operating the charge avalanche photodetector (1) without a bias voltage V_{bias} and with the amplifier electronics (2) switched off.
• Total gain mode 1: Operating the charge avalanche photodetector (1) without a bias voltage V_{bias} and with the amplifier electronics (2) switched on.
• Total gain mode 2: Operating the charge avalanche photodetector (1) with a bias voltage V_{bias} and with the amplifier electronics (2) switched off.
• Total gain mode 3: Operating the charge avalanche photodetector (1) with a bias voltage V_{bias} and with the amplifier electronics (2) switched on.

5. CAPD system in accordance with one of the preceding claims, **characterized in that** the charge avalanche photodetector (1) is or comprises a silicon photomultiplier, SiPM.

6. CAPD system in accordance with one of the preceding claims, **characterized in that** the multi-stage transimpedance amplifier is a three-stage transimpedance amplifier.

7. CAPD system in accordance with one of the preceding claims, **characterized in that** the charge avalanche photodetector (1) is configured in/as a first module (3), and that the amplifier electronics (2) is configured in/as a second module (4), wherein the first module (3) and the second module (4) are preferably arranged spatially separately from one another.

8. CAPD system in accordance with one of the preceding claims, **characterized in that** the charge avalanche photodetector (1) is embedded or is arranged in/at a cooling element (5), in particular in/at a heat sink.

9. Use of a CAPD system in accordance with one of the claims 1 to 8 for photodetection, wherein the semiconductor photomultiplier (1) is selectively operated either with a bias voltage V_{bias} or without a bias voltage V_{bias}.

## Revendications

1. Système photodétecteur à avalanche de charges (système LP) comprenant un photodétecteur à avalanche de charges (1) reposant sur le principe d'avalanche de charges, de préférence un photomultiplicateur à semi-conducteur ou une photodiode à avalanche,
dans lequel le système LP comporte une électronique d'amplification (2) connectée électriquement en aval (1-2) du photodétecteur à avalanche de charges (1),
dans lequel le photodétecteur à avalanche de charges (1) peut fonctionner soit avec une tension de polarisation V_{bias}, soit sans une telle tension de polarisation V_{bias},
**caractérisé en ce que** le système LP, à la fois lors du fonctionnement du photodétecteur à avalanche de charges (1) avec une tension de polarisation V_{bias} et lors du fonctionnement du photodétecteur à avalanche de charges (1) sans une telle tension de polarisation V_{bias}, peut fonctionner soit avec l'électronique d'amplification (2) allumée, soit avec l'électronique d'amplification (2) éteinte,
dans lequel l'électronique d'amplification (2) comprend un amplificateur à transimpédance à plusieurs étages.

2. Système LP selon la revendication précédente,
**caractérisé en ce que**
le passage d'un fonctionnement avec une tension de polarisation V_{bias} à un fonctionnement sans une telle tension de polarisation V_{bias}, ou vice versa, survient au moyen de l'électronique d'amplification (2), de préférence au moyen d'une électronique de commande intégrée dans l'électronique d'amplification (2).

3. Système LP selon l'une quelconque des revendications précédentes, **caractérisé en ce que**
le photodétecteur à avalanche de charges (1) peut être commuté entre le mode Geiger, un mode d'intégration de charges et/ou un mode photodiode PIN.

4. Système LP selon l'une quelconque des revendications précédentes, **caractérisé en ce que**
le système LP peut fonctionner dans les modes de mesure suivants, peut également être commuté d'un quelconque à un autre quelconque des modes de mesure répertoriés ci-dessous, ou peut au moins être commuté entre des modes de mesure immédiatement adjacents dans l'ordre suivant :
• Mode de gain global 0 : Fonctionnement du photodétecteur à avalanche de charges (1) sans tension de polarisation V_{bias} et électronique d'amplification (2) désactivée.
• Mode de gain global 1 : Fonctionnement du photodétecteur à avalanche de charge (1) sans tension de polarisation V_{bias} et électronique d'amplification (2) activée.
• Mode de gain global 2 : Fonctionnement du photodétecteur à avalanche de charges (1) avec tension de polarisation V_{bias} et électronique d'amplification (2) désactivée.
• Mode de gain global 3 : Fonctionnement du photodétecteur à avalanche de charges (1) avec tension de polarisation V_{bias} et électronique d'amplification (2) activée.

5. Système LP selon l'une quelconque des revendications précédentes, **caractérisé en ce que**
le photodétecteur à avalanche de charges (1) est ou comprend un photomultiplicateur au silicium, SiPM.

6. Système LP selon l'une quelconque des revendications précédentes, **caractérisé en ce que**
l'amplificateur à transimpédance à plusieurs étages est un amplificateur à transimpédance à trois étages.

7. Système LP selon l'une quelconque des revendications précédentes, **caractérisé en ce que**
le photodétecteur à avalanche de charges (1) est conçu dans/comme un premier module (3) et **en ce que** l'électronique d'amplification (2) est conçue dans/comme un second module (4),
dans lequel, de préférence, le premier module (3) et le second module (4) sont agencés espacés spatialement l'un de l'autre.

8. Système LP selon l'une quelconque des revendications précédentes, **caractérisé en ce que**
le photodétecteur à avalanche de charges (1) est encastré ou agencé dans/sur un élément de refroidissement (5), en particulier dans/sur un dissipateur thermique.

9. Utilisation d'un système LP selon l'une des revendications 1 à 8 pour une photodétection, dans laquelle le photomultiplicateur à semi-conducteur (1) fonctionne sélectivement soit avec une tension de polarisation V_{bias}, soit sans tension de polarisation V_{bias}.
